# EUROPÄISCHE PATENTSCHRIFT

(11) **EP 2 051 866 B1**
(45) Veröffentlichungstag und Bekanntmachung des Hinweises auf die Patenterteilung: **27.01.2010**
(21) Anmeldenummer: 07730114.1
(22) Anmeldetag: 13.06.2007
(51) Int. Cl.: B60C 23/04, H01L 41/113

(54) **SCHALTUNGSMODUL**
CIRCUIT MODULE
MODULE DE CIRCUIT

(30) Priorität: 11.08.2006 DE 102006037693; 14.02.2007 DE 102007006994
(43) Veröffentlichungstag der Anmeldung: 29.04.2009
(73) Patentinhaber: Robert Bosch GmbH, 70442 Stuttgart (DE)
(72) Erfinder: REICHENBACH, Ralf, 73732 Esslingen (DE); KECK, Marian, 72766 Reutlingen (DE)
(86) Internationale Anmeldenummer: PCT/EP2007/055807
(87) Internationale Veröffentlichungsnummer: WO 2008/017533

(56) Entgegenhaltungen:
- WO-A-2004/030949
- WO-A-2006/072539
- WO-A-2007/000781
- US-A- 4 384 482

## Beschreibung

Die Erfindung betrifft ein Schaltungsmodul, insbesondere Sensormodul, das vorzugsweise als Reifensensormodul in einen Fahrzeugreifen einsetzbar ist, sowie einen Fahrzeugreifen mit einem derartigen Schaltungsmodul.

### Stand der Technik

Reifensensoren dienen insbesondere zur Messung des Reifeninnendrucks (tire pressure monitoring system, TPMS), der Temperatur oder der im Reifen auftretenden Beschleunigung. Das Sensormodul weist hierzu in der Regel einen Schaltungsträger bzw. ein Substrat, mindestens ein Sensorbauelement und eine Antenne auf, über die an eine Sende- Empfangseinrichtung am Fahrzeug Daten übermittelt werden.

Zur Energieversorgung sind neben der Einstrahlung elektromagnetischer Wellen insbesondere Systeme mit einer autarken Energieversorgung durch eine Batterie bzw. galvanische Zelle bekannt. Aus Umweltschutzgründen treten jedoch hohe Entsorgungskosten und ein hoher Aufwand der Trennung bei der Demontage auf. Reifensensormodule mit Batterien sind in der Regel an der Reifenfelge zu montieren, da die als Batterien eingesetzten galvanischen Zellen getrennt vom Gummimaterial des Reifens zu entsorgen sind und den beim Einvulkanisieren im Reifen auftretenden Temperaturen nicht stand halten. Weiterhin ist die Betriebsdauer durch die Kapazität der oft nicht auswechselbaren Batterie begrenzt; da die Größe des Sensormoduls begrenzt ist, können auch die Batterien nicht sehr groß dimensioniert werden.

Die Verwendung piezoelektrischer Elemente zur Stromversorgung bzw. Energieversorgung autarker Module ist im Allgemeinen nicht unproblematisch, da die piezoelektrischen Elemente aus in der Regel spröden Keramiken hergestellt werden und daher die jeweilige Biegebeanspruchung bei zu großen Auslenkungen zur Zerstörung führen kann. Komplexere Systeme mit Piezo-Elementen erfordern oftmals einen größeren Bauraum, was zu höheren Kosten und bei Integration des Moduls in einem Fahrzeugreifen gegebenenfalls zu einer unzulässigen Größe führen kann.

Aus der WO 2004/0309049 A1 ist ein Telemetriesender bekannt, der in einen Fahrzeugreifen eingebaut werden kann. Um Energie zur Ausstrahlung der ermittelten Daten zu erhalten, ist in dem Sender ein piezoelektrischer Generator untergebracht. Der Generator erzeugt mittels einer Durchbiegung eines Piezoelements bei einer Reifenumdrehung zyklische Pulse von elektrischer Energie, die gespeichert und entsprechend zur Aussendung von Druck- und Temperaturdaten verwendet werden kann.

Aus der US 4,384,482 A ist ein Reifenzustandswarnsystem bekannt, welches in Fahrzeugreifen verwendet werden kann. Zur Energieversorgung des Systems ist ein beschwerter Ausleger vorgesehen, welche mit einer piezoelektrischen Wandlereinheit verbunden ist. Die übliche Radbewegungen wird der Ausleger zu Vibrationen angeregt, die durch die Wandlereinheit in elektrische Energie zur Versorgung des Systems umgewandelt wird.

### Offenbarung der Erfindung

Erfindungsgemäß wird ein piezoelektrischer Generator mit den Merkmalen des Anspruchs 1 als Feder-Masse-System gebildet, der als Spannungsquelle in dem Schaltungsmodul eine autarke Energieversorgung ermöglicht. Hierdurch kann insbesondere ein Reifensensor, z.B. ein Reifendruckkontrollsensor (TPMS), mit Sensor- und Funkelektronik autark mit Energie versorgt werden. Weiterhin sind auch andere Anwendungen als autarkes Modul, das kontinuierlichen oder diskontinuierlichen mechanischen Belastungen ausgesetzt ist, möglich.

Der piezoelektrische Generator weist ein bewegbares Masseelement bzw. eine seismische Masse auf, die in dem Gehäuse des Schaltungsmoduls geführt ist und mit einer gehäuseseitig angebundenen Federeinrichtung zusammenwirkt.

Das Piezo-Element ist erfindungsgemäß Teil der Federeinrichtung, wobei es grundsätzlich auch alleine die Federeinrichtung darstellen kann. Gemäß einer bevorzugten Ausführungsform ist jedoch ein zusätzliches Federelement vorgesehen, an dem das piezoelektrische Element derartig befestigt ist, dass es bei der Schwingung der seismischen Masse durch die elastische Verformung der Federeinrichtung durchgebogen wird und hierdurch eine Piezospannung erzeugt, die über seine an der Ober- und Unterseite ausgebildeten Elektroden abgegriffen und über eine Stromversorgungsschaltung den Komponenten des Schaltungsmoduls zur Verfügung gestellt wird.

Indem erfindungsgemäß ein Masse-Feder-System eingesetzt wird, kann durch geeignete Auslegung der Federkonstante und der Masse die Resonanzfrequenz so gewählt werden, dass eine hohe Energieausbeute erreicht wird.

Dem liegt die erfindungsgemäße Erkenntnis zugrunde, dass bei geringen Geschwindigkeiten im Reifen die größten Beschleunigungen im Frequenzbereich kleiner 500 Hz zur Verfügung stehen, d.h. es liegt ein breitbandiges Frequenzspektrum bei insbesondere kleineren Frequenzen vor. Die Beschleunigungswerte nehmen mit Abnahme der Frequenz zu. Der erfindungsgemäße piezoelektrische Generator schwingt bei einer breitbandigen Anregung, wie sie in einem Fahrzeugreifen bei der Fahrt auftritt, mit seiner Resonanzfrequenz, so dass durch geeignete Auslegung des Massewertes und der Federkonstanten hohe Energieausbeuten möglich sind. Erfindungsgemäß kann die Resonanzfrequenz nunmehr für eine hohe bzw. maximale Leistungsabgabe im Bereich der höchsten Beschleunigungen ausgelegt werden; hierbei können insbesondere niedrige Eigenfrequenzen eingestellt werden.

Erfindungsgemäß können der zur Verfügung stehende Bauraum berücksichtigt und hierdurch die Dimensionierung und Größe der Masse und die Federlänge, Federbreite und Federdicke eingestellt werden. Zum Erreichen niedriger Resonanzfrequenzen können erfindungsgemäß insbesondere die Masse und Federlänge maximiert und die Federbreite und Federdicke minimiert werden.

Erfindungsgemäß kann das Masseelement direkt in seiner Form dem Innenquerschnitt des Gehäuses angepasst sein, so dass es bei seiner Schwingbewegung durch das Gehäuse geführt und zumindest an einem Ende durch das Gehäuse und/oder den Schaltungsträger begrenzt wird. Hierdurch füllt das Masseelement den zur Verfügung stehenden Bauraum optimal aus, so dass das Masseelement maximiert wird. Grundsätzlich können ggf. weitere Mittel bzw. Lagen in das Gehäuse zur Führung des Masseelementes sowie zur Definition eines Anschlags eingebracht werden; dies ist jedoch erfindungsgemäß grundsätzlich überflüssig, da das Gehäuse direkt Führung und den Anschlag darstellen kann.

Die Federeinrichtung wird vorteilhafterweise durch eine metallische Blattfeder gebildet, die in dem Gehäuse fest aufgenommen, vorzugsweise eingespannt ist. Sie kann insbesondere in einer Gehäusenut mit verlängerten Endbereichen festgelegt werden und um diese Befestigungspunkte bzw. Einspannpunkte eine Schwingung durchführen. Bei Verwendung einer metallischen Blattfeder können deren Massekontaktbereiche an der seismischen Masse anliegen und somit deren Schwingbewegung mit vollziehen, und Federbereiche die elastische Federwirkung bilden. Hierbei können insbesondere zwei (oder mehr) gegenüber den Masseauflageflächen verstellbare Federbereiche an ihren Endbereichen im Gehäuse aufgenommen sein und somit bei der Schwingung den zwischen ihnen eingeschlossenen Winkel ändern.

Gerade die Aufnahme der Enden der Federbereiche im Gehäuse ermöglicht eine sichere, definierte Schwingung bei einer großen Variabilität bzw. Auslegungsmöglichkeit der Federkonstanten durch geeignete Formgebung dieser Federbereiche. Die Enden können hierbei jeweils auf ihrer Ober- und Unterseite aufgenommen sein, mit ihren stirnseitigen Kanten jedoch freiliegen, so dass die Kanten bei der Schwingung nicht stirnseitig in dem Gehäuse anschlagen.

Durch die erfindungsgemäße klemmende Ausnahme der Enden der Federbereiche mit leichtem Spiel, insbesondere ohne stirnseitigen Anschlag, kann eine geringe Resonanzfrequenz, insbesondere geringer als bei z.B. einer festen Einspannung erreicht werden. Weiterhin ist keine zusätzliche stabile Verankerung aus festen Materialien erforderlich.

Das Gehäuse kann insbesondere mit rundem Querschnitt, d.h. im Wesentlichen zylinderförmig beziehungsweise linsenförmig ausgebildet sein. Hierdurch wird eine hohe Druckbeständigkeit beim Einvulkanisieren ermöglicht; weiterhin wird der zur Verfügung stehende Bauraum durch die weiteren Komponenten gut ausgenutzt, wobei das Masseelement entsprechend zylindrisch ist und im Gehäuse geführt ist, und als Federeinrichtung entsprechend eine im Wesentlichen rundes Federblech mit durch Strukturierung ausgebildeten Federbereichen gebildet wird, wobei die Federbereiche mit überstehenden Endbereichen in dem Gehäuse aufgenommen werden.

Die zylindrische Masse füllt den gesamten Bauraum aus und erreicht hierdurch ein geometrisches Optimum. Über die Höhe bzw. axiale Erstreckung des zylindrischen Masseelementes kann der Massewert eingestellt werden.

Das spröde Keramikmaterial des Piezo-Elementes wird erfindungsgemäß nicht in die Einspannung und Masseankopplung involviert und hierdurch vor Schock und Überlastung geschützt.

Das Piezoelement kann in Länge und Abmessungen so gestaltet werden, dass es bei dem ausgebildeten Feder-Masse-System eine gute oder sogar optimale Durchbiegung erfährt. Hierbei können die Länge des - im Wesentlichen streifenförmigen - Piezoelementes, seine Breite und die Anbindungspunkte an den Federbereichen gewählt werden.

Die Begrenzung der maximalen Auslenkung des Feder-Masse-Systems kann durch den Anschlag der Masse beziehungsweise des Federblechs am Gehäuse ausgebildet werden; das Piezoelement bleibt hierbei geschützt.

Da das Federblech auch bei geringer Materialstärke eine hohe Stabilität aufweist und das Keramikmaterial des Piezo-Elements im Feder-Masse-System keine tragende Rolle spielt, können beide Elemente in ihrer Materialstärke reduziert werden. Dies führt zu geringeren Resonanzfrequenzen.

Da das Piezo-Element an die Federeinrichtung angekoppelt wird und eine Biegeschwingung durchführt, beeinflusst es entsprechend die Federkonstante des Gesamtsystems. Dies wird bei der Auslegung berücksichtigt.

Das piezoelektrische Element ist auf seiner Ober- und Unterseite mit einer elektrisch leitenden Schicht beschichtet, die als untere bzw. obere Elektrode dient. Zur elektrischen Kontaktierung kann zum einen die metallische Federeinrichtung, d.h. insbesondere ein metallisches Federblech genutzt werden und hierbei die untere Elektrode kontaktieren. Zum anderen kann die auf der Oberseite des piezoelektrischen Elementes ausgebildete obere Elektrode über ein weiteres Kontaktierungsmittel, z.B. einen Draht, eine flexible Leiterplatte oder ein flexibles Metallblech kontaktiert werden.

Somit wird erfindungsgemäß eine sichere, Material schonende Aufnahme des Piezo- Elementes und ein konstruktiv in seinen Parametern in weiten Bereichen anpassbares Feder-Masse-System, insbesondere auch zur Ausbildung niedriger Resonanzfrequenzen bei einer sicheren Aufnahme im Gehäuse unter definiertem Anschlag des Masseelements erreicht.

### Kurze Beschreibung der Zeichnungen

Es zeigen:
- Fig. 1 a, b: den piezoelektrischen Generator des Schaltungsmoduls in per- spektivischer Ansicht im Zusammenbau (a) und Explosionszeich- nung (b),
- Fig. 2: einen Querschnitt durch ein erfindungsgemäßes Schaltungsmo- dul.

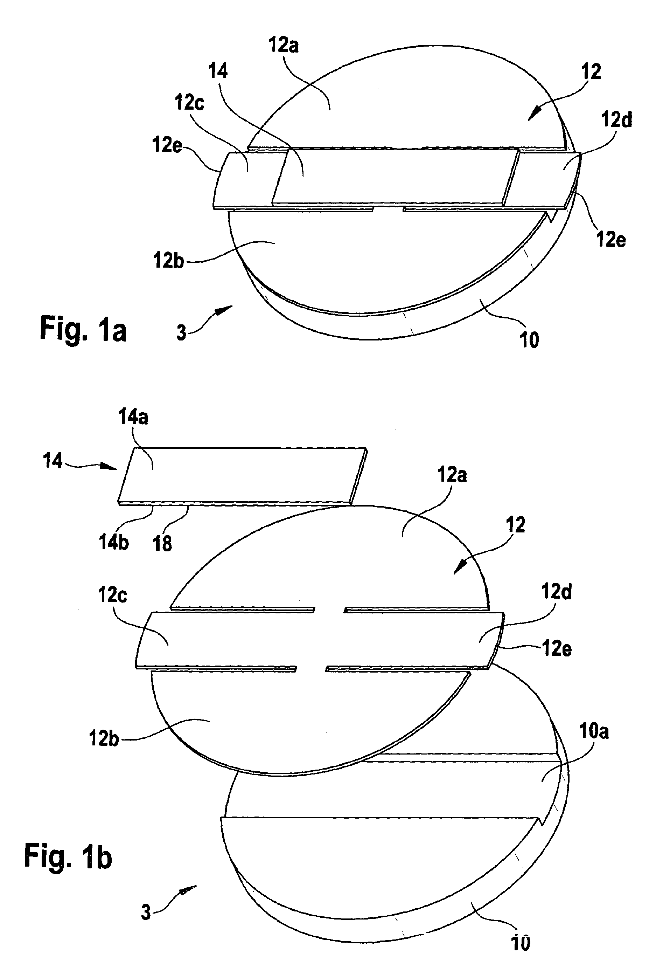

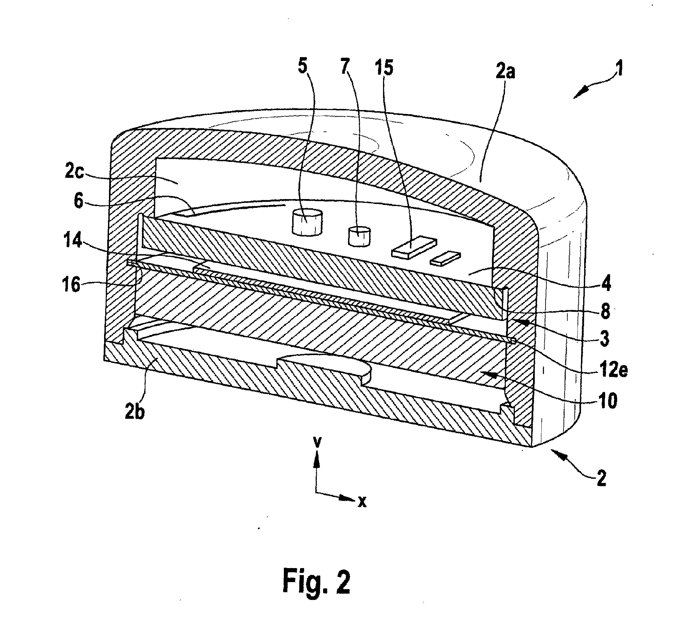

Das in Fig. 2 im Querschnitt gezeigte Schaltungsmodul 1 weist ein Gehäuse 2 mit einem topfförmigen Gehäuseoberteil 2 a und einem deckelförmigen bzw. scheibenförmigen Gehäuseunterteil 2 b auf und umgibt einen Gehäuseinnenraum 2 c. In dem Gehäuseinnenraum 2 c sind ein in Fig. 1 a, b detaillierter gezeigter piezoelektrischer Generator (PEG) 3 und ein Schaltungsträger 4 mit hier nur angedeuteter Modulelektronik 5, 7, 15 aus SMD-Bauelementen aufgenommen. Die Modulelektronik 5, 7, 15 kann je nach Einsatz des Schaltungsmoduls 1 unterschiedliche Bauelemente aufweisen. Hierbei ist eine Stromversorgungsschaltung 5 zur Aufnahme der Piezo-Spannung und zur Bereitstellung der Versorgungsspannung, vorteilhafterweise auch ein Energiespeicher zur Zwischenspeicherung der Energie bei zeitweise diskontinuierlichem Betrieb vorgesehen. Bei Verwendung als Reifendruckkontrollsystem (TPMS) sind weiterhin ein Drucksensor 7 und als Bauelemente 15 eine Steuereinheit, z.B. ein ASIC, und für den Betrieb der Antenne relevante HF-Bauteile, z.B. ein Oszillator und ggf. ein HF-ASIC, auf dem z.B. als Leiterplatte ausgebildeten Schaltungsträger 4 montiert. Die in Fig. 2 angedeutete Antenne 6 kann z.B. als Schleifenantenne am äußeren Rand des Schaltungsträgers 4 umlaufen; grundsätzlich kann die Antenne 6 jedoch z.B. auch im oder am Gehäuse 2, z.B. an der Innenwand des Gehäuses 2 verlaufen oder auch in das Gehäuse 2 eingespritzt sein. Bei Verwendung als Reifendruckkontrollsystem weist das Gehäuse 2 ein Loch als Druckzuführung von außen auf.

Vorteilhafterweise weisen das Gehäuse 2 und der Schaltungsträger 4 eine zumindest weitgehend rotationssymmetrische bzw. runde Form auf, so dass das Schaltungsmodul 1 beim Einspritzen als Reifensensormodul in das Gummimaterial eines Reifens keine unerwünschte Ausrichtung erfährt, keine unerwünschten Ecken oder Kanten aufweist und eine rotationssymmetrische Abstrahlcharakteristik seiner Antenne 6 aufweist.

In dem Gehäuse 2 kann z.B. eine Kante bzw. ein Absatz 8 ausgebildet sein, an dem der Schaltungsträger 4 derartig anliegt bzw. aufgenommen ist, dass die Modulelektronik 5, 7, 15 auf seiner in Fig. 2 gezeigten Oberseite frei nach oben in den Gehäuseinnenraum 2 c ragen kann, ohne an das Gehäuse 2 zu stoßen; sie wird weiterhin auch nicht durch den unterhalb des Schaltungsträgers 4 vorgesehenen piezoelektrischen Generator 3 beeinträchtigt.

Der piezoelektrische Generator 3 weist gemäß Fig. 1 a, b ein in dem Gehäuseinnenraum 2 c bewegbar bzw. verstellbar aufgenommenes Masseelement 10, ein metallisches Federelement 12 und ein piezoelektrisches Element 14 auf. Das piezoelektrische Element 14 ist bei dieser Ausführungsform als streifenförmige Monolage einer piezoelektrischen Keramik ausgebildet; das metallische Federelement 12 ist im Wesentlichen als Blattfeder ausgebildet und weist in Fig. 1 a, b unten und oben dargestellte Massekontaktbereiche 12 a, b auf, die mit ihrer Unterseite an dem Masseelement 10 anliegen. Zwischen ihnen sind elastische Federbereiche 12 c, d angeordnet, die gegenüber den Massekontaktbereichen verstellbar sind. Hierbei kann in dem Masseelement 10 unterhalb der Federbereiche 12c, d eine entsprechend breite Nut 10a oder Vertiefung ausgebildet sein, in die die Federbereiche 12c, d hineingelangen können, wenn das Masseelement nach oben gegen die Massekontaktbereiche 10a, b drückt.

Die Federbereiche 12 c, d weisen radial nach außen weisende, überstehende äußeren Endbereiche 12 e auf, die gemäß Fig. 2 in Gehäusenuten 16 des Gehäuseoberteils 2 a eingelegt, vorzugsweise eingespannt sind. Grundsätzlich können die Endbereiche 12 e stirnseitig am Nutgrund der Gehäusenut 16 eingespannt sein. Vorteilhafterweise sind die Endbereiche 12 e jedoch nicht stirnseitig eingespannt bzw. berühren den Nutgrund nicht mit ihren Stirnkanten, um eine Schwingbewegung der Federbereiche 12 c, d zu ermöglichen, bei der sich der Abstand der beiden Endbereiche 12 e verändert; es ist somit im Wesentlichen eine Einspannung an der Oberseite und Unterseite der Endbereiche 12 e mit der Möglichkeit einer freien Schwingbewegung vorgesehen. Durch die Lagerung an Ober- und Unterseite statt der stirnseitigen Einspannung wird eine niedrigere Resonanzfrequenz möglich.

Das streifenförmige piezoelektrische Element 14 weist an seiner Oberseite 14a eine als obere Elektrode dienende metallische Schicht und an seiner Unterseite 14b eine als untere Elektrode dienende metallische Schicht auf; die Oberseite 14a und Unterseite 14b dienen somit direkt als obere Elektrode 14a bzw. untere Elektrode 14b. Hierbei liegt das piezoelektrische Element 14 auf den beiden Federbereichen 12 c, d auf und ist auf diesen an seiner Unterseite 14b bzw. unteren Elektrode 14b in einer Verbindungsschicht 18, z.B. Leitkleber oder Lot, elektrisch leitfähig befestigt, die auch zum Abgriff der Piezospannung Up dient. Die Kontaktierung der Oberseite 14a bzw. oberen Elektrode 14a kann gemäß Fig. 2 direkt auf der Unterseite des Schaltungsträgers 4, z.B. durch einen aufgelegten Draht, entsprechende Kontaktpads bzw. metallische Flächenbereiche des Schaltungsträgers 4 oder ein eingelegtes flexibles Metallblech erfolgen.

Das Masseelement 10 füllt vorteilhafterweise den gesamten Querschnitt des Gehäuseinnenraums 2 a aus, d.h., es ist im Wesentlichen als zylindrische Scheibe ausgebildet. Hierdurch werden zwei Vorteile erreicht:
Zum einen kann eine große Masse erreicht werden und somit niedrige Resonanzfrequenzen bzw. niederfrequente Eigenschwingungen;
zum anderen wird das Masseelement 10 hierdurch an den Innenwänden des Gehäuses 2 geführt, so dass es nicht seitlich verkippen kann und somit eine gleichmäßige Schwingbewegung gewährleistet wird.

Entsprechend ist vorteilhafterweise auch das metallische Federelement 12 dem Querschnitt des Gehäuseinnenraums 2 c in seiner Form angepasst, d.h. gemäß der gezeigten Ausführungsform rund bzw. scheibenförmig ausgebildet, wobei die Endbereiche 12 e radial vorstehen zur Aufnahme in den Gehäusenuten 16. Auch der Schaltungsträger 4 ist vorteilhafterweise rund bzw. zylindrisch ausgebildet, so dass er sicher an den Innenwänden des Gehäuses 2 anliegt und die zur Verfügung stehende Fläche ausnutzt.

Grundsätzlich sind auch von der runden Form abweichend Ausbildungen des Gehäuses 2 und der in ihm aufgenommenen Elemente 4, 12 und 10 möglich, z.B. eine etwas elliptische oder ovale Form; auch in dem Fall sollte allerdings die Antenne 6 als im Wesentlichen kreisförmig geschlossene Schleifenantenne ausgebildet sein, um eine homogene Abstrahlcharakteristik zu gewährleisten.

Bei einer mechanischen Belastung, insbesondere durch Beschleunigungen bzw. Vibrationen in vertikaler (axialer) Richtung V, d.h. in der Stapelrichtung der gezeigten Anordnung bzw. der Symmetrieachse der zylindrischen Gehäuseform, kann nunmehr das Masseelement 10 in dem in Fig. 2 unteren Bereich des Gehäuseinnenraums 2 a eine Schwingung ausführen, die nach unten durch Gehäuseunterteil (Gehäuseboden) 2 b und nach oben durch das Federelement 12 begrenzt ist. Das in der Aufnahme im Gehäuseinnenraum 2a gehaltene Federelement 12 wirkt somit als Wegbegrenzung bzw. Anschlag der Schwingbewegung des Masseelementes 10. Der Anschlagabstand ist durch den Abstand des Federelementes 12 von dem Masseelement 10, also durch die Tiefe der Massenut 10a definiert.

Bei der Schwingung des Masseelementes 10 werden die Federbereiche 12 c, d aus der horizontalen X-Ebene der Massekontaktbereiche 12 a, b hinausgedrückt und federn wieder zurück. Das an ihnen befestigte piezoelektrische Element führt dementsprechend eine Biegeschwingung aus und erzeugt zwischen seiner Oberseite 14 a und seiner Unterseite 14 b eine sich zeitlich ändernde Piezospannung U_{P}, die im Allgemeinen ihr Vorzeichen wechselt.

Die Federkonstante des piezoelektrischen Generators der Fig. 1, 2 wird durch die Federkonstante der Federbereiche 12 c, d und auch durch das versteifend wirkende, auf den Federbereichen 12 c, d befestigte piezoelektrische Element 14 bestimmt. Die Federkonstante der Federbereiche 12 c, d kann insbesondere durch geeignete Formgebung der Federbereiche 12 c, d festgelegt werden. Durch geeignete Auswahl der Masse m des Masseelementes 10 sowie der Federkonstanten der gesamten Federeinrichtung aus dem Federelement 12 und dem piezoelektrischen Element 14 kann somit die Eigenfrequenz gewählt werden. Vorzugsweise werden Resonanzfrequenzen im Bereich von 10 bis 600 Hz, vorzugsweise 300 bis 500 Hz gewählt.

Der radiale Durchmesser des in Fig. 2 gezeigten Schaltungsmoduls 1 beträgt vorzugsweise zwischen 15 und 5 mm, insbesondere ist er kleiner als 25 mm. Die Höhe ist vorteilhafterweise etwas geringer.

Da bei piezoelektrischen Keramiken vielfach höhere Druckspannungen als Zugspannungen zulässig sind, können die Anschläge des Feder-Masse-Systems auch so ausgelegt werden, dass eine höhere Auslenkung des Piezoelements in Stauchrichtung als in Dehnungsrichtung möglich ist. Bei der Stauchrichtung handelt es sich gemäß dem in Fig. 2 dargestellten Koordinatensystem um die entgegen zu V weisende Richtung, bei der Dehnungsrichtung um die parallel zu V weisende Richtung. In einem rollenden Reifen wird der piezoelektrische Generator insbesondere so eingebaut, dass die auftretende Radialbeschleunigung das Feder-Masse-System mit den Bauteilen 10, 12 und 14 stets in Stauchungsrichtung des Piezoelements auslenkt. Die z.B. infolge von Straßenunebenheiten auftretenden Vibrationen lassen das System symmetrisch um diese Lage schwingen. Der Arbeitspunkt des Generators ist somit durch eine relativ zur Ruhelage versetzte Auslenkung definiert und variiert mit der Winkelgeschwindigkeit des Reifens. Dieses Verhalten kann für beliebige Beigebalkenkonzepte genutzt werden, insbesondere auch für einseitig eingespannte Biegebalken.

Um eine mechanische Überbelastung in Zugspannungsrichtung des Piezoelements sicher zu verhindern, kann der Anschlag zwischen Feder- und Masseelement so ausgelegt werden, dass die Feder in Ihrer Ruhelage am Masseelement anliegt, d.h. es wird keine Vertiefungsnut im Masseelement vorgesehen. D.h. die Vertiefungsnut 10a in Fig. 1b kann auch weggelassen werden.

Im Vergleich zu symmetrisch gewählten Anschlägen kann mit dieser speziellen Ausführung der Anschläge des Feder-Masse-Systems insbesondere in einem rollenden Reifen eine deutlich höhere elektrische Energie erzeugt werden. Gleichzeitig wird eine hohe mechanische Zuverlässigkeit erreicht.

Die Anschläge des Feder-Masse-Systems zur Begrenzung der maximalen Auslenkung können beidseitig durch das Modulgehäuse realisiert werden. Hierbei existieren insbesondere in der das Piezoelement auf Dehnung beanspruchenden Auslenkungsrichtung hohe Anforderungen an die Fertigungstoleranzen. Diese Auslenkung kann alternativ oder zusätzlich durch den Anschlag des Masseelements 10 an die Federeinrichtung 12 begrenzt werden. Um eine zusätzliche Auslenkung in diese Richtung zu ermöglichen, kann eine Vertiefungsnut 10a im Masseelement vorgesehen werden. Die Nuttiefe bestimmt den zulässigen Weg. Insbesondere bei Reifensensormodulen kann aufgrund der vorherrschenden Radialbeschleunigung und zur Verbesserung der Zuverlässigkeit auf die Vertiefungsnut verzichtet werden

Allgemein kann das Masseelement 10 bei seiner Schwingbewegung beidseitig durch je einen Anschlag begrenzt werde. Dabei ist es möglich, dass die beiden Abstände zwischen dem Masseelement in seiner Ruheposition und den Anschlägen unterschiedlich sind oder sogar, dass zwischen einem der Anschläge und dem Masseelement in seiner Ruheposition kein Abstand besteht. Bei dem Anschlag, welcher keinen Abstand zum Masseelement in seiner Ruheposition aufweist, um kann es sich z.B. um den Blattfederbereich bzw. elastischen Federbereich 12 c, d zur Anlage an dem Masseelement 10 handeln.

In oder an einem Fahrzeugreifen kann das Schaltungsmodul derart angebracht werden, dass die vertikale Achsrichtung des Gehäuses (V) in die Radialrichtung des Reifens weist, wobei das Massenelement 10 bzgl. der Radialrichtung weiter außen als das piezoelektrische Element 14 angeordnet ist. Dann wird aufgrund der durch die Rollbewegung des Reifens hervorgerufenen Radialbeschleunigung das Massenelement bzgl. des Reifens in Radialrichtung ausgelenkt.

Es ist auch möglich, dass das Schaltungsmodul derart an oder in einem Fahrzeugreifen angebracht ist, dass die vertikale Achsrichtung des Gehäuses (V) in die axiale oder tangentiale Richtung des Reifens weist.

Der beschriebene piezoelektrische Generator für Reifensensormodule wandelt im Ausführungsbeispiel die in Reifen auftretenden radialen Beschleunigungen in elektrische Energie. Prinzipiell ist aber auch die Wandlung von axial oder tangential auftretenden Vibrationen möglich.

## Patentansprüche

1. Schaltungsmodul, insbesondere zum Einsatz in einem Fahrzeugreifen, das mindestens
- ein Gehäuse (2),
- einen piezoelektrischen Generator (3), der innerhalb des Gehäuses (2)
- ein bewegbares Masseelement (10) und
- eine Federeinrichtung (12, 14) mit mindestens einem piezoelektrischen Element (14)
aufweist,
wobei
- die Federeinrichtung (12, 14) durch das piezoelektrische Element (14) und mindestens ein Federelement (12) gebildet ist, die miteinander verbunden sind und
- das Federelement (12) mindestens einen Massekontaktbereich (12 a, b) zur Anlage an dem Masseelement (10) und mindestens einen elastischen Federbereich (12 c, d) zur elastischen Verformung aufweist, und
- das Masseelement (10) und die Federeinrichtung (12, 14) ein schwingfähiges System bilden und das piezoelektrische Element (14) bei der Schwingung des schwingfähigen Systems (10, 12, 14) elastisch verformbar ist, und
- das Piezoelement (14) an dem mindestens einen elastischen Federbereich (12 c, d) befestigt ist und bei einer elastischen Verformung des elastischen Federbereichs (12 c, d) eine Biegung durchführt,
- eine Stromversorgungsschaltung (5) zur Aufnahme einer von dem piezoelektrischen Element (14) bei seiner mechanischen Verformung ausgegebenen Piezo-Spannung und zur Stromversorgung des Schaltungsmoduls (1).
aufweist,
**dadurch gekennzeichnet dass**
das Federelement (12) zwei zungenartige, radial nach außen abstehende elastische Federbereiche (12 c, d) aufweist und das piezoelektrische Element (14) an den beiden Federbereichen (12 c, d) befestigt ist zur Durchführung einer Biegeschwingung.

2. Schaltungsmodul nach Anspruch 1, **dadurch gekennzeichnet, dass** das Federelement (12) in dem Gehäuse (2) befestigt ist.

3. Schaltungsmodul nach Anspruch 2, **dadurch gekennzeichnet, dass** das Federelement (12) Endbereiche (12 e) aufweist, die mindestens einer Gehäusenut (16) des Gehäuses eingelegt bzw. eingeklemmt sind.

4. Schaltungsmodul nach Anspruch 3, **dadurch gekennzeichnet, dass** stirnseitige Kanten der Endbereiche (12 e) in mindestens einer Gehäusenut (16) des Gehäuses freiliegen und bei einer Schwingbewegung in ihrem Abstand zueinander verstellbar sind.

5. Schaltungsmodul nach einem der vorherigen Ansprüche, **dadurch gekennzeichnet, dass** das piezoelektrische Element (14) eine längliche Streifenform aufweist, die orthogonal zur vertikalen Achsrichtung (V) des Gehäuses (2) verläuft.

6. Schaltungsmodul nach einem der vorherigen Ansprüche, **dadurch gekennzeichnet, dass** das Masseelement (10) bei seiner Schwingbewegung an der Innenwand des Gehäuses (2) geführt ist.

7. Schaltungsmodul nach einem der vorherigen Ansprüche, **dadurch gekennzeichnet, dass** das Masseelement (10) und die Federeinrichtung (12, 14) den Querschnitt des Gehäuseinnenraums (2 c) ausfüllen.

8. Schaltungsmodul nach Anspruch 7, **dadurch gekennzeichnet, dass** ein Schaltungsträger (4) für die Stromversorgungsschaltung (7) und mindestens ein weiteres Bauelement (5) in dem Gehäuseinnenraum (2c) aufgenommen ist.

9. Schaltungsmodul nach Anspruch 8, **dadurch gekennzeichnet, dass** der Schaltungsträger (4), das piezoelektrische Element (14), das Federelement (12) und das Masseelement (10) in dem Gehäuse (2) gestapelt sind, wobei das Federelement (12) auf dem Masseelement (10) aufliegt, das piezoelektrische Element (14) auf der Oberseite oder Unterseite des Federelements (12) angebracht ist und der Schaltungsträger (4) auf dem piezoelektrischen Element (14) vorgesehen ist.

10. Schaltungsmodul nach Anspruch 8 oder 9, **dadurch gekennzeichnet, dass** das piezoelektrische Element (14) mit seiner als untere Elektrode ausgebildeten Unterseite (14b) über das metallisch ausgebildete Federelement (12) und mit seiner als obere Elektrode ausgebildeten Oberseite (14a) über einen mit dem Schaltungsträger (4) verbundenen oder angebrachten Leiter, z.B. einen Draht oder ein flexibles Metallblech, kontaktiert ist.

11. Schaltungsmodul nach einem der vorherigen Ansprüche, **dadurch gekennzeichnet, dass** die Stromversorgungsschaltung (5) einen Energiespeicher zur Zwischenspeicherung der von dem Piezoelement erzeugten Energie aufweist.

12. Schaltungsmodul nach einem der vorherigen Ansprüche, **dadurch gekennzeichnet, dass** das piezoelektrische Element (14) die einzige Energiequelle des Schaltungsmoduls (1) ist und das Schaltungsmodul (1) energetisch autark und frei von sich verbrauchenden Energiequellen ist.

13. Schaltungsmodul nach einem der vorherigen Ansprüche, **dadurch gekennzeichnet, dass** es einen Sensor (7) zur Messung des Drucks und/oder der Temperatur und/oder der Beschleunigung aufweist.

14. Schaltungsmodul nach einem der vorherigen Ansprüche, **dadurch gekennzeichnet, dass** das schwingfähige System (10, 12, 14) eine Eigenfrequenz von 10 bis 600 Hz, vorzugsweise 300 bis 500 Hz aufweist.

15. Schaltungsmodul nach Anspruch 6, **dadurch gekennzeichnet, dass** das Masseelement (10) bei seiner Schwingbewegung beidseitig durch je einen Anschlag begrenzt wird.

16. Schaltungsmodul nach Anspruch 15, **dadurch gekennzeichnet, dass** die beiden Abstände zwischen dem Masseelement in seiner Ruheposition und den Anschlägen unterschiedlich sind.

17. Schaltungsmodul nach Anspruch 16, **dadurch gekennzeichnet, dass** zwischen einem der Anschläge und dem Masseelement in seiner Ruheposition kein Abstand besteht.

18. Schaltungsmodul nach Anspruch 17, **dadurch gekennzeichnet, dass** es sich beim dem Anschlag, welcher keinen Abstand zum Masseelement in seiner Ruheposition aufweist, um den elastischen Federbereich (12 c, d) zur Anlage an dem Masseelement (10) handelt.

19. Fahrzeugreifen mit einem Schaltungsmodul nach einem der vorherigen Ansprüche, **dadurch gekennzeichnet, dass** das Schaltungsmodul (1) in dem Gummimaterial des Fahrzeugreifens eingebracht, z. B. einvulkanisiert, eingeklebt, in einer Tasche aufgenommen oder eingeklemmt ist.

20. Fahrzeugreifen mit einem Schaltungsmodul nach einem der vorherigen Ansprüche, **dadurch gekennzeichnet, dass** das Schaltungsmodul derart an oder in einem Fahrzeugreifen angebracht ist, dass die vertikale Achsrichtung des Gehäuses (V) in die Radialrichtung des Reifens weist, wobei das Massenelement (10) bzgl. der Radialrichtung weiter außen als das piezoelektrische Element (14) angeordnet ist

21. Fahrzeugreifen mit einem Schaltungsmodul nach Anspruch 16, **dadurch gekennzeichnet, dass** aufgrund der durch die Rollbewegung des Reifens hervorgerufenen Radialbeschleunigung das Massenelement bzgl. des Reifens in Radialrichtung ausgelenkt wird.

22. Fahrzeugreifen mit einem Schaltungsmodul nach einem der vorherigen Ansprüche, **dadurch gekennzeichnet, dass** das Schaltungsmodul derart an oder in einem Fahrzeugreifen angebracht ist, dass die vertikale Achsrichtung des Gehäuses (V) in die axiale oder tangentiale des Reifens weist.

## Claims

1. Circuit module, in particular for use in a vehicle tyre, which has at least
- a housing (2),
- a piezoelectric generator (3) which has within the housing (2)
- a movable earth element (10) and
- a spring device (12, 14) with at least one piezoelectric element (14),
wherein
- the spring device (12, 14) is formed by the piezoelectric element (14) and at least one spring element (12) which are connected to one another,
and
- the spring element (12) has at least one earth contact region (12 a, b) for bearing against the earth element (10) and at least one elastic spring region (12 c, d) for the purpose of elastic deformation, and
- the earth element (10) and the spring device (12, 14) form an oscillatory system, and the piezoelectric element (14) can be deformed elastically when the oscillatory system (10, 12, 14) oscillates, and
- the piezo element (14) is attached to the at least one elastic spring region (12 c, d) and it bends when the elastic spring region (12 c, d) deforms elastically,
- a power supply circuit (5) for picking up a piezovoltage which is output by the piezoelectric element (14) during its mechanical deformation, and for supplying power to the circuit module (1),
**characterized in that**
the spring element (12) has two tongue-like elastic spring regions (12 c, d) which protrude radially outward, and the piezoelectric element (14) is attached to the two spring regions (12 c, d) in order to carry out a bending oscillation.

2. Circuit module according to Claim 1, **characterized in that** the spring element (12) is attached in the housing (2).

3. Circuit module according to Claim 2, **characterized in that** the spring element (12) has end regions (12 e) which are inserted or clamped into at least one housing groove (16) in the housing.

4. Circuit module according to Claim 3, **characterized in that** front-side edges of the end regions (12 e) are exposed in at least one housing groove (16) in the housing and their distance from one another can be adjusted during an oscillatory movement.

5. Circuit module according to one of the preceding claims, **characterized in that** the piezoelectric element (14) has an elongate strip form which runs orthogonally with respect to the vertical axial direction (V) of the housing (2).

6. Circuit module according to one of the preceding claims, **characterized in that** the earth element (10) is guided on the inner wall of the housing (2) during the oscillatory movement of said earth element (10).

7. Circuit module according to one of the preceding claims, **characterized in that** the earth element (10) and the spring device (12, 14) fill the cross section of the interior (2 c) of the housing.

8. Circuit module according to Claim 7, **characterized in that** a circuit carrier (4) for the power supply circuit (7) and at least one further component (5) are accommodated in the interior (2 c) of the housing.

9. Circuit module according to Claim 8, **characterized in that** the circuit carrier (4), the piezoelectric element (14), the spring element (12) and the earth element (10) are stacked in the housing (2), wherein the spring element (12) rests on the earth element (10), the piezoelectric element (14) is mounted on the upper side or lower side of the spring element (12), and the circuit carrier (4) is provided on the piezoelectric element (14).

10. Circuit module according to Claim 8 or 9, **characterized in that** the piezoelectric element (14) is placed in contact by its underside (14b), which is embodied as a lower electrode, via the spring element (12) which is embodied in a metallic fashion, and by its upper side (14a), embodied as an upper electrode, via a conductor, for example a wire or a flexible metal sheet, which is connected to or mounted on the circuit carrier (4).

11. Circuit module according to one of the preceding claims, **characterized in that** the power supply circuit (5) has an energy accumulator for buffering the energy generated by the piezoelement.

12. Circuit module according to one of the preceding claims, **characterized in that** the piezoelectric element (14) is the only energy source of the circuit module (1), and the circuit module (1) is energetically autonomous and free of depleting energy sources.

13. Circuit module according to one of the preceding claims, **characterized in that** said circuit module has a sensor (7) for sensing the pressure and/or the temperature and/or the acceleration.

14. Circuit module according to one of the preceding claims, **characterized in that** the oscillatory system (10, 12, 14) has a natural frequency of 10 to 600 Hz, preferably 300 to 500 Hz.

15. Circuit module according to Claim 6, **characterized in that** the earth element (10) is limited during its oscillatory movement on both sides by a stop in each case.

16. Circuit module according to Claim 15, **characterized in that** the two distances between the earth element in its position of rest and the stops are different.

17. Circuit module according to Claim 16, **characterized in that** there is no distance between one of the stops and the earth element in its position of rest.

18. Circuit module according to Claim 17, **characterized in that** the stop which is not at a distance from the earth element in its position of rest is the elastic spring region (12 c, d) for bearing against the earth element (10).

19. Vehicle tyre having a circuit module according to one of the preceding claims, **characterized in that** the circuit module (1) is introduced into the rubber material of the vehicle tyre, e.g. vulcanized or bonded in, and held or clamped in a pocket.

20. Vehicle tyre having a circuit module according to one of the preceding claims, **characterized in that** the circuit module is mounted on or in a vehicle tyre in such a way that the vertical axial direction of the housing (V) points in the radial direction of the tyre, wherein the earth element (10) is arranged further outward with respect to the radial direction than the piezoelectric element (14).

21. Vehicle tyre having a circuit module according to Claim 16, **characterized in that**, owing to the radial acceleration caused by the rolling movement of the tyre, the earth element is deflected in the radial direction with respect to the tyre.

22. Vehicle tyre having a circuit module according to one of the preceding claims, **characterized in that** the circuit module is mounted on or in a vehicle tyre in such a way that the vertical axial direction of the housing (V) points in the axial or tangential directions of the tyre.

## Revendications

1. Module de circuit, destiné en particulier à être utilisé dans un bandage de roue de véhicule et présentant :
- un boîtier (2),
- un générateur piézoélectrique (3) qui présente à l'intérieur du boîtier (2)
un élément de masse mobile (10) et
un dispositif élastique (12, 14) qui présente au moins un élément piézoélectrique (14),
le dispositif élastique (12, 14) étant formé par l'élément piézoélectrique (14) et au moins un élément élastique (12), les deux étant reliés l'un à l'autre,
l'élément élastique (12) présentant au moins une partie de contact de masse (12a, b) destinée à être placée contre l'élément de masse (10) et au moins une partie élastique (12c, d) qui permet une déformation élastique,
l'élément de masse (10) et le dispositif élastique (12, 14) formant un système oscillant et l'élément piézoélectrique (14) pouvant être déformé élastiquement lors de l'oscillation du système oscillant (10, 12, 14),
le piézoélément (14) étant fixé sur la ou les parties élastiques (12c, d) et subissant une flexion en cas de déformation élastique de la partie élastique (12c, d),
le module de circuit présentant :
- un circuit (5) d'alimentation en courant qui reçoit la tension piézoélectrique délivrée par l'élément piézoélectrique (14) lors de sa déformation mécanique et qui alimente le module de circuit (1) en courant,
**caractérisé en ce que**
l'élément élastique (12) présente deux parties élastiques (12c, d) en formé de languette débordant radialement vers l'extérieur et
**en ce que** l'élément piézoélectrique (14) est fixé sur les deux parties élastiques (12c, d) de manière à exécuter une oscillation en flexion.

2. Module de circuit selon la revendication 1, **caractérisé en ce que** l'élément élastique (12) est fixé dans le boîtier (2).

3. Module de circuit selon la revendication 2, **caractérisé en ce que** l'élément élastique (12) présente des parties d'extrémité (12e) placées ou serrées dans au moins une rainure (16) du boîtier.

4. Module de circuit selon la revendication 3, **caractérisé en ce que** les bords frontaux des parties d'extrémité (12e) sont posés librement dans au moins une rainure (16) du boîtier et **en ce que** leur distance mutuelle varie lors du déplacement oscillant.

5. Module de circuit selon l'une des revendications précédentes, **caractérisé en ce que** l'élément piézoélectrique (14) présente la forme d'un ruban allongé qui s'étend perpendiculairement à la direction de l'axe vertical (V) du boîtier (2).

6. Module de circuit selon l'une des revendications précédentes, **caractérisé en ce que** l'élément de masse (10) est guidé sur la paroi intérieure du boîtier (2) pendant son déplacement d'oscillation.

7. Module de circuit selon l'une des revendications précédentes, **caractérisé en ce que** l'élément de masse (10) et le dispositif élastique (12, 14) remplissent la section transversale de l'espace intérieur (2c) du boîtier.

8. Module de circuit selon la revendication 7, **caractérisé en ce qu'**un porte-circuit (4) du circuit (7) d'alimentation en courant et au moins un autre composant (5) sont logés dans l'espace intérieur (2c) du boîtier.

9. Module de circuit selon la revendication 8, **caractérisé en ce que** le porte-circuit (4), l'élément piézoélectrique (14), l'élément élastique (12) et l'élément de masse (10) sont empilés dans le boîtier (2), **en ce que** l'élément élastique (12) repose sur l'élément de masse (10) et l'élément piézoélectrique (14) est placé sur le côté supérieur ou le côté inférieur de l'élément élastique (12) et **en ce que** le porte-circuit (4) est prévu sur l'élément piézoélectrique (14).

10. Module de circuit selon les revendications 8 ou 9, **caractérisé en ce que** les contacts de l'élément piézoélectrique (14) sont formés sur son côté inférieur (14b) configuré comme électrode inférieure par l'élément élastique (12) en métal et sur son côté supérieur (14a) configuré comme électrode supérieure par un conducteur, par exemple un fil ou une tôle métallique flexible, appliqué sur le porte-circuit (4) ou relié à ce dernier.

11. Module de circuit selon l'une des revendications précédentes, **caractérisé en ce que** le circuit (5) d'alimentation en courant présente un accumulateur d'énergie qui permet l'accumulation temporaire de l'énergie produite par le piézoélément.

12. Module de circuit selon l'une des revendications précédentes, **caractérisé en ce que** l'élément piézoélectrique (14) est la seule source d'énergie du module de circuit (1) et **en ce que** le module de circuit (1) est énergétiquement autonome et ne présente pas de sources d'énergie épuisables.

13. Module de circuit selon l'une des revendications précédentes, **caractérisé en ce qu'**il présente un détecteur (7) de mesure de la pression, de la température et/ou de l'accélération.

14. Module de circuit selon l'une des revendications précédentes, **caractérisé en ce que** le système oscillant (10, 12, 14) a une fréquence propre de 10 à 600 Hz et de préférence de 300 à 500 Hz.

15. Module de circuit selon la revendication 6, **caractérisé en ce que** le déplacement d'oscillation de l'élément de masse (10) est limité de chaque côté par une butée.

16. Module de circuit selon la revendication 15, **caractérisé en ce que** les distances entre l'élément de masse en position de repos et les butées sont différentes.

17. Module de circuit selon la revendication 16, **caractérisé en ce qu'**aucun écart n'existe entre l'une des butées et l'élément de masse en position de repos.

18. Module de circuit selon la revendication 17, **caractérisé en ce que** la butée qui ne présente pas d'écart par rapport à l'élément de masse en position de repos est la partie élastique (12c, d) destinée à être placée sur l'élément de masse (10).

19. Bandage de roue de véhicule doté d'un module de circuit selon l'une des revendications précédentes, **caractérisé en ce que** le module de circuit (1) est placé dans le matériau de caoutchouc du bandage de roue de véhicule, par exemple par vulcanisation, collage, réception dans une poche ou serrage.

20. Bandage de roue de véhicule doté d'un module de circuit selon l'une des revendications précédentes, **caractérisé en ce que** le module de circuit est placé sur ou dans un bandage de roue de véhicule de telle sorte que la direction de l'axe vertical du boîtier (V) soit orientée dans la direction radiale du bandage de roue et que dans la direction radiale, l'élément de masse (10) soit disposé plus à l'extérieur que l'élément piézoélectrique (14).

21. Bandage de roue de véhicule doté d'un module de circuit selon la revendication 16, **caractérisé en ce que** l'accélération radiale provoquée par le déplacement de roulement du bandage dévie l'élément de masse dans la direction radiale du bandage de roue.

22. Bandage de roue de véhicule doté d'un module de circuit selon l'une des revendications précédentes, **caractérisé en ce que** le module de circuit est placé sur ou dans un bandage de roue de véhicule de telle sorte que la direction de l'axe vertical (V) du boîtier soit orientée dans la direction axiale ou tangentielle du bandage de roue.
